# DEMANDE DE BREVET EUROPEEN

(11) **EP 2 341 472 A1**
(43) Date de publication de la demande: **06.07.2011**
(21) Numéro de dépôt: 09306315.4
(22) Date de dépôt: 22.12.2009
(51) Int. Cl.: G06K 19/077, H01L 21/00

(54) **Procédé de réalisation par transfert d'un dispositif électronique comportant une interface de communication**

(71) Demandeur: Gemalto SA, 92190 Meudon (FR)
(72) Inventeur: Fidalgo, Jean-Christophe, 13420 Gemenos (FR); Roussel, François, 13390 Auriol (FR); Leveque, Olivier, 83140 Six Fours (FR)

(57) **Abrégé**

La présente invention concerne un procédé de réalisation d'un dispositif électronique / électrique (1,20,30) comportant une interface de communication à antenne (2) et/ou à contacts électriques, ladite interface de communication étant formée sur un support initial (3) selon une première densité (D1) par unité de surface ou de longueur du support;
Il se distingue en ce qu'il comprend une étape de transfert d'au moins une interface (2,12) sur ou dans un second support définitif (7,15) selon une seconde densité (D2).
L'invention concerne également le dispositif obtenu.

## Description

La présente invention concerne un procédé de réalisation d'un dispositif électronique comportant une interface de communication à antenne et/ou à contacts électriques.

En particulier, l'invention concerne un procédé de fabrication d'inserts ou inlays qui représentent le coeur de certains objets intelligents tels que des cartes à puce, des passeports électroniques. Un insert ou "inlay" comprend un microcircuit (puce nue ou module à puce de circuits intégrés) relié à une antenne radiofréquence de manière à communiquer avec un lecteur externe.

Plusieurs procédés de réalisation d'antenne sont connus. Parmi ces procédés se trouvent notamment les procédés à base de fil conducteur utilisant un fil incrusté par ultrasons, un fil bobiné; Il existe aussi des procédés de type soustractif utilisant la gravure de cuivre ou d'aluminium; Enfin, il existe des procédés de type additif ou semi-additif tels que la métallisation électrolytique (ou electroless en anglais) de cuivre, de nickel ou d'or, le dépôt de matière par impression, jet de matière ou sérigraphie d'encre conductrice.

Ces procédés ont l'inconvénient de ne pas offrir de souplesse dans le choix du support de l'interface et/ou d'être onéreux. Ainsi par exemple, en gravure si l'on effectue un support d'antenne pour passeport, le coût de la gravure est élevé par rapport d'autres procédés..

En outre, le support qui est adapté pour un procédé de réalisation d'antenne, n'est pas nécessairement adapté au produit final. Par exemple, les procédés de dépôt chimique électrolytique ou electroless ne sont pas adaptés à un support fibreux non plastique tel que du papier, par exemple.

L'invention a pour but de résoudre les inconvénients précités.

L'invention vise un procédé de réalisation d'interface notamment à antenne qui soit économique et permette d'avoir un support de création de l'interface adapté au produit final.

Le principe de l'invention selon un mode préféré consiste à utiliser un support initial externe pour la fabrication ou la création d'un motif d'interface puis un support définitif exempt ou dépourvu d'un support initial externe ayant supporté l'antenne pendant sa formation.

A cet effet, l'invention a pour objet un procédé de réalisation d'un dispositif électronique / électrique comportant une interface de communication à antenne et/ou à contacts électriques, ladite interface de communication étant formée sur un support initial selon une première densité (D1) par unité de surface ou de longueur du support;

Le procédé se distingue en ce qu'il comprend une étape de transfert d'au moins deux interfaces de ladite pluralité d'interfaces sur ou dans un second support définitif selon une seconde densité (D2).

Selon d'autres caractéristiques du procédé
- La seconde densité (D2) est inférieure à la première densité (D1);
- Ledit dispositif comprend une puce de circuit intégré connectée à l'interface;
- L'interface est une antenne formée à plat sur un support;
- Le premier et/ou second support comprend une bande (3) de bobine 4;
- Le transfert comprend une étape de fixation du support définitif sur les circuits sur leur côté opposé à celui orienté vers le support initial et une étape d'enlèvement d'au moins un support initial externe;
- L'étape de fixation est choisie parmi une opération telle qu'un transfert à chaud, une lamination, un surmoulage, une coextrusion.
- L'interface est une antenne passive (12) et en ce qu'il comprend le transfert et la connexion d'un micromodule à capacité (STC) sur ladite antenne passive et/ou le transfert d'un micromodule à antenne (M, 10) avec circuit intégré de manière à être associé sur le support définitif.

L'invention a également pour objet un dispositif électronique comportant au moins un circuit électrique/électronique comprenant une interface de communication à antenne et/ou à contacts électriques sur un support définitif; Il se distingue en ce que ledit support définitif de l'interface est exempt d'un support initial externe de formation de l'interface.

Ainsi, le substrat définitif de l'interface est indépendant du substrat de création ou utilisé lors de la création de l'interface.

D'autres particularités et avantages de l'invention apparaîtront à la lecture de la description, faite à titre d'exemple non limitatif et en regard des dessins annexés sur lesquels :
- La figure 1 illustre la formation d'antenne sur un premier support selon un premier mode de mise en oeuvre du procédé de l'invention;
- La figure 2 est une coupe A-A de la figure 1 ;
- La figure 3 illustre une étape de transfert selon le premier mode de mise en oeuvre du procédé de l'invention;
- La figure 4 illustre une variante de mise en oeuvre d'un autre type de dispositif selon le premier mode de mise en oeuvre du procédé de l'invention avec un transfert double d'antenne passive et de module à microcircuit;
- La figure 4b est une coupe selon B-B de la figure 4a illustrant un microcircuit M à antenne;
- La figure 5 illustre la formation d'antenne sur un premier support selon un deuxième mode de mise en oeuvre du procédé de l'invention;
- La figure 6 illustre un apport de matériau sur le premier support ou les interfaces selon le deuxième mode de mise en oeuvre du procédé de l'invention;
- La figure 6a illustre une coupe C-C de la figure 6;
- La figure 7 illustre l'enlèvement d'au moins le support externe du support initial selon le deuxième mode de mise en oeuvre du procédé de l'invention.

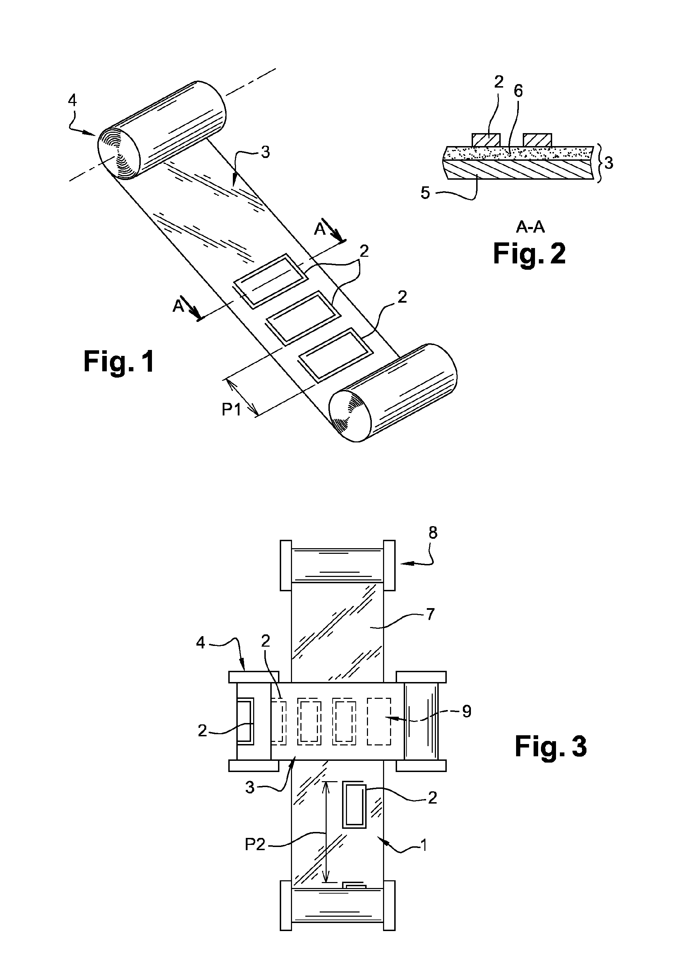

A la figure 1 est illustrée une première étape du procédé de réalisation d'un dispositif électronique / électrique 1 comportant une interface de communication 2 à antenne ou à contacts électriques.

Dans cette étape, selon l'invention on réalise une pluralité de circuits électriques / électroniques 2 comportant chacun une interface de communication à antenne ou à contact sur un support initial 3 selon une première densité D1 par unité de surface ou de longueur. Les circuits 2 sont ici espacés d'un pas P1 inférieur à la largeur de 2 motifs de circuit. Les circuits sont orientés selon une première orientation dans laquelle le petit côté de l'antenne parallèle au côté longitudinal de la bande 3.

Dans l'exemple, des circuits comprennent des antennes et sont réalisés notamment par dépôt additif de matière conductrice sur une bande 3 de bobine 4, mais on pourrait tout autant réaliser des interfaces à contacts électriques. Dans la présente demande, ce qui est décrit pour une antenne s'applique aussi pour des contacts ou pistes électriques. Les interfaces pourraient toutefois être réalisées sur un support en plaque ou avec d'autres procédés de réalisation d'antennes connus comme un procédé de type gravure.

De préférence, les motifs d'antenne 2 sont agencés très proches les uns des autres pour améliorer la productivité des antennes par unité de surface ou de longueur. En même temps, on effectue une économie des composés chimiques nécessaires au dépôt. L'antenne est ici gravée selon une densité d'antenne d'environ 18 antennes au mètre linéaire, la largeur et longueur étant respectivement de 5 cm environ 8 cm.

Les procédés de gravure ou autres procédés de réalisation additifs ou soustractifs nécessitent des supports compatibles standards, comme le PET, qui ne sont pas nécessairement les bienvenus dans le produit final qui peut notamment nécessiter du papier ou avoir des propriétés physiques, chimiques ou mécaniques très éloignées. Inversement, le substrat d'antenne du substrat final, par exemple en papier, n'est pas nécessairement adapté aux procédés de production d'antenne par méthode additive ou soustractive, ni aux phases aqueuses ou bains et réactifs employés.

Conformément à une caractéristique, le procédé de l'invention comprend une étape de transfert d'au moins un et de préférence au moins deux circuits 2 de ladite pluralité de circuits provenant d'un support initial 3 vers un second support définitif 5.

A cet effet, le support initial 3 est choisi de manière à permettre un transfert ultérieur des interfaces 2; Par exemple, le support comprend en coupe (figure 2) un ruban ou feuille amovible externe 5 revêtue d'une matière 6 facilitant le détachement du ruban ou la feuille amovible (par exemple, une cire, un film thermofusible)

A la figure 3, l'étape de transfert est illustrée sur ou dans un second support 7 pour former un dispositif 1 comportant au moins une antenne ou une pluralité d'antennes 2. Pour cela, on dispose le premier support 3 en défilement perpendiculaire par rapport à un second support 7 définitif de l'antenne. Dans l'exemple, le second support 7 est également une bande continue mais pourrait être une plaque ou des plaques discontinues, par exemple défilant sous le premier support.

Inversement, le premier support pourrait être sous forme de plaque de plus ou moins grandes dimensions et le second support pourrait être sous forme de plaque, de ruban ou bande.

Des indexations par des trous, mires ou autres moyens équivalents notamment video ou VAO (Vision Assisté par Ordinateur) sont prévues pour déterminer précisément les positions des antennes à transférer par rapport aux positions du second support.

Chaque circuit 2 du support 3 est reporté ou transféré (illustrée par la flêche T) sur le second support 7 en laissant son emplacement 9 libre après transfert. Les antennes ont une seconde orientation sur le second support (différente de la première) dans laquelle les antennes ont leur grand côté (côté longitudinal) parallèle au bord longitudinal de la bande du support définitif 7. Le procédé peut utiliser de manière connue un outil de transfert de type marquage à chaud (ou hot stamping en anglais)

De manière à assurer l'adhésion sur le second support 7 et le décollement du premier support 5, le second support 7 peut être recouvert d'une couche d'adhésif thermoactivable,

Conformément à une caractéristique de l'invention, on peut effectuer le transfert des antennes selon une seconde densité D2 distincte ou non de la première. Dans l'exemple, la seconde densité peut être inférieure à la première densité d'un facteur 2 ou 3 ou 4 ou 5 à 10. Le second support est ici un support en papier naturel ou synthétique poreux destiné à des passeports électroniques. En l'occurrence, le pas (P1) entre deux antennes sur le ruban correspond à une longueur de couverture de passeport ou 2 pages de passeport, par exemple un pas de 10 cm entre chaque antenne. On comprend bien qu'une telle densité d'antenne n'aurait pas été intéressante économiquement à produire par gravure notamment, avec une aussi faible densité de motif d'antenne.

Dans le cas de la réalisation d'une antenne, il peut être nécessaire de réaliser un pont conducteur permettant de ramener la spire externe vers l'intérieur. Une fois le transfert d'antenne effectué sur le substrat définitif, le pont peut-être réalisé par des procédés classiques: sérigraphie d'une encre isolante au dessus des pistes à traverser puis sérigraphie d'une piste en encre conductrice. Un autre procédé possible pour réaliser le pont serait d'utiliser un ruban conducteur (strap en anglais) avec un film isolant au moins dans sa partie centrale. Ce pont conducteur peut être connecté aux deux pistes d'antenne à relier notamment par la technique de connexion par déformation mécanique et contact électrique à travers un isolant (sertissage-clinchage ou "crimp" en anglais).

Pour terminer le circuit sans contact, il faudra alors reporter et connecter soit directement la puce soit le micromodule sur l'antenne.

Dans d'autres variantes de réalisation, il est possible ou non de connecter un microcircuit à l'antenne sur le premier support initial. Le transfert s'applique alors à l'ensemble comprenant l'antenne et le microcircuit. La connexion peut être de tout type connu, le microcircuit pouvant être nu ou conditionné dans un module ou un enrobage.

Dans une autre variante, la puce comporte une antenne notamment gravée ou intégrée à la surface de la puce de circuit intégré; La puce (IC) peut être reliée à une antenne 10 et/ou être portée par un module comprenant une antenne de faible dimension notamment de 15 à 20 mm environ pour la plus grande distance entre éléments extrêmes de l'antenne.

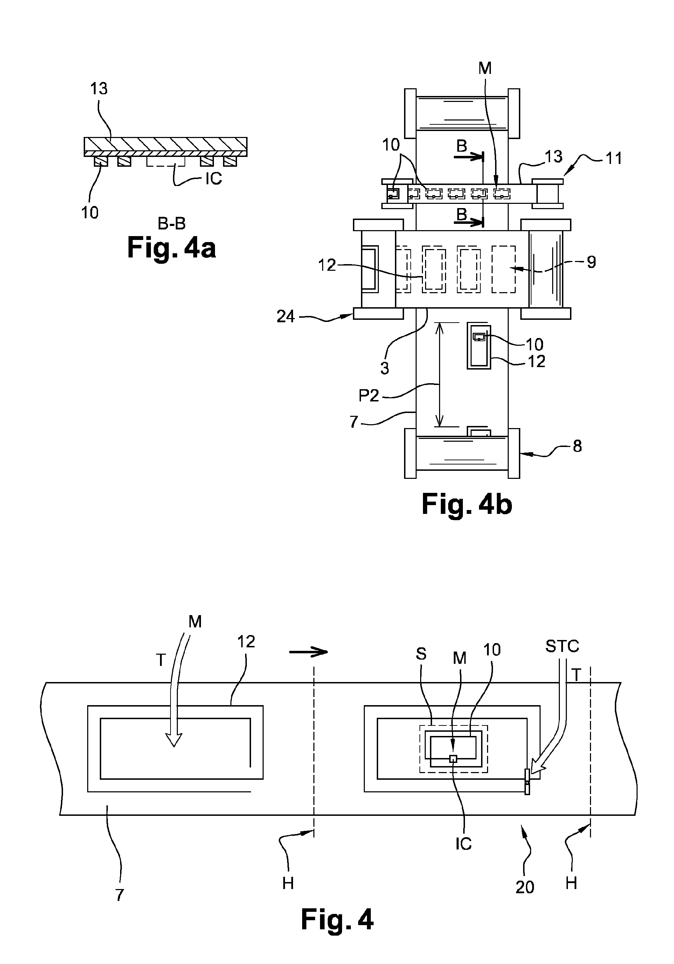

La figure 4 illustre un transfert (T) de micromodules radiofréquences à antenne M ou antennes seules 10 à partir d'une autre bobine 11 portant une pluralité de ces modules ou transpondeurs ou antennes avec une densité élevée optimale (motifs quasi jointifs ou adjacents les uns des autres). Cette opération est effectuée ici dans l'exemple parallèlement ou postérieurement à l'opération de transfert d'une l'antenne passive 12.

Sur cette figure, les mêmes numéros illustrent les mêmes éléments que sur les figures précédentes. A la différence de la figure 3, on transfère d'une part une antenne passive 12 au lieu d'une antenne 2 connectée ou destinée à être connectée à un circuit intégré IC et d'autre part un mini-circuit M. Le transfert peut être effectué aussi par voie thermique et pression comme précédemment;

Le cas échéant, en alternative, le transfert comprend une découpe du ruban initial temporaire 13 avec une antenne et/ou un micromodule puis un report sur le support définitif approprié 7 et selon une densité appropriée. En d'autres termes, le transfert peut concerner l'antenne seule, l'antenne connectée à une puce, l'antenne (connectée ou non à une puce) avec une portion de support temporaire, une antenne de plusieurs centimètres de large ou de long et un transpondeur M (mini-antenne avec sans puce électronique). A chaque fois, l'élément transféré peut être purement fonctionnel électriquement (conducteur ou semi-conducteur) ou accompagné d'une portion de substrat.

La figure 4a illustre une coupe du ruban 13 portant une pluralité de micromodules M; Les micromodules comprennent au moins une mini-antenne 10 et le cas échéant une puce connectée à la mini-antenne.

A la figure 4b, le microcircuit ou module M est représenté avec un substrat S (en pointillé) mais pourrait ne pas comprendre de substrat S à en plus du second support définitif 7.

On utilise une antenne relais ou antenne passive 12 de grande dimension (reliée le cas échéant à des capacités); On transfère par l'opération illustrée par la flèche T (fig.4a) l'antenne de grande dimension 12 d'une part et un mini-transpondeur radiofréquence M (module antenne) d'autre part sur un support définitif 7. Le cas échéant, un support temporaire peut être commun ou non à l'antenne passive et au transpondeur radiofréquence M.

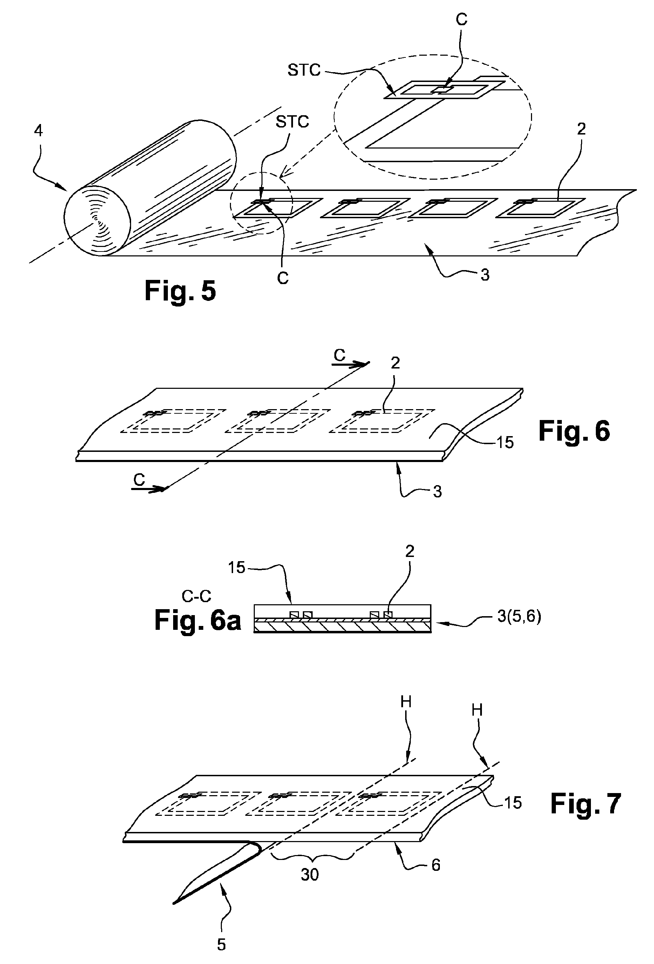

L'antenne relais est connectée à une capacité C sous forme de composant (ou puce) monté en surface; La capacité est reliée ici à un module de capacité STC ou (strap) formant un pont conducteur au dessus des spires d'antenne, le pont étant isolé par un film isolant au moins au niveau des spires pour éviter un court-circuit. La connexion du module de capacité peut s'effectuer par tout moyen connu comme pour la connexion d'un module de puce radiofréquence à la figure 5.

Pratiquement, le procédé de connexion d'une capacité peut mettre ne oeuvre une autre bobine (non représentée) comme la bobine de micomodules 11 mais qui comprendrait une pluralité de microdules STC de capacité. Le transfert sur les extrémités d'antenne peut s'effectue également par transfert thermique.

Alternativement, on peut réaliser des plaques de condensateur aux extrémités de l'antenne par la même technique ayant servi à réaliser l'antenne notamment par bains électrolytiques.

De préférence, il est plus avantageux de réaliser classiquement et économiquement d'un côté des micromodules à antenne M (puce avec mini-antenne) sur un ruban de bobine (technologie dite "reel to reel"); Et d'un autre côté, on réalise une grande antenne passive (12), par exemple d'une dimension sensiblement de la dimension d'une carte à puce ISO 7816 et sur un support plastique genre PET classique; L'antenne est configurée de manière à être accordée en fréquence et coopérer avec le mini transpondeur pour relayer les communications).

Lors de l'étape de transfert selon un mode quelconque, l'antenne peut être chauffée et enfoncée sur le substrat final. Le procédé de transfert à chaud (hot stamping) peut être utilisé pour effectuer cette opération de transfert. Le cas échéant, le transfert est effectué de manière que l'emplacement du microcircuit se trouve enfoncé dans une cavité du support définitif. La cavité peut être réalisée lors de l'opération de marquage à chaud ou par un thermoformage préalable du substrat.. De façon plus classique le transfert de l'antenne peut être effectué sur un substrat plan et la compensation de la puce ou du module peut être effectuée par report d'une feuille préalablement découpée à cet emplacement.

L'antenne peut comporter des résidus du support initial adhérent à sa surface notamment de la matière 6. La puce ou microcircuit peut recevoir le cas échéant un enrobage dur permettant de le rigidifier pour le transfert ou souple pour absorber les contraintes de pression. La puce peut être le cas échéant porté par une grille métallique surmoulée formant le module transféré.

Au cours de cette opération, l'invention permet d'avoir un stock unique d'antennes 2, 12 pouvant servir à effectuer différents types "d'inlays" ou d'inserts avec des densités différentes d'antennes ou des rapports surface d'antenne / surface de support différents d'un lot à l'autre

Aux figures 5 et suivantes, un autre mode de mise en oeuvre du procédé de l'invention est illustré. Dans ce mode, les éléments transférés peuvent être de la même nature que ceux décrits précédemment bien que l'exemple relatif au transfert d'une pluralité d'antennes uniquement. Les mêmes produits finaux que précédemment peuvent être obtenus (antenne connectée ou non à une puce, antenne passive accordée à un mini transpondeur radiofréquence.

Conformément à ce mode, on réalise une pluralité d'antennes 2 sur un ruban 3 de PET (ou autre matériau approprié classique). Le substrat 3 peut être un film bicouche qui comporte une couche de matière 6 destinée à être au contact de l'antenne et un film "pelable" externe 5 ou détachable de la couche..

Le cas échéant, le film 5 peut avoir une propriété intrinsèque non adhésive (téflon ou autre qui lui permet de ne pas bien adhérer ou moins adhérer à un autre support définitif et dans ce cas, il pourrait ne pas y avoir de couche 6. En alternative, lors du pelage du film externe 5, une couche de matière 6 peut rester accrochée ou collée à l'antenne ou matériau définitif 15 portant l'antenne.

Comme précédemment, d'autres procédés de réalisation d'antenne parmi ceux connus de l'homme de l'art peuvent convenir.

Conformément à une caractéristique du second mode de mise en oeuvre procédé, on effectue préalablement au transfert une étape de fixation d'un support définitif 15 sur les circuits sur leur côté opposé à celui orienté vers le support initial 3; Dans l'exemple, à la figure 6, on effectue un apport d'un matériau 15 constituant un support définitif et approprié de l'antenne. En l'occurrence, il s'agit d'un ruban de "Teslin" poreux laminé sur le ruban 3.

Cet apport ou fixation peut résider en une opération telle qu'un surmoulage, une coextrusion, une pulvérisation, une enduction une lamination d'un film ou couche au dessus de l'antenne ou de la pluralité d'antennes. On observe à la figure 6a, une coupe montrant une antenne 2 prise en sandwich entre le support initial temporaire 3 et support définitif 15. Le support initial 3 peut former comme précédemment un bicouche 5,6.

Ensuite, à la figure 7 selon une caractéristique du procédé, on effectue l'enlèvement du support initial externe 5 au moins. Ce procédé permet, par exemple, de transférer l'antenne sur du papier ou substrat plus adapté à l'application passeport. Dans le cas où le support est un multicouche, au moins la couche ou ruban externe initial externe est retiré.

Un microcircuit, ou une puce de circuit intégré ou un micromodule peut être connecté quand l'antenne est sur le support initial 3 ou après transfert de l'antenne sur le support définitif 15. Dans ce dernier cas, l'extraction du film temporaire (5 ou 3) peut mettre à jour au moins les points des connexions ou extrémités de l'antenne pour connecter un microcircuit. La connexion peut être effectuée par tout moyen connu notamment par puce retournée (flip-chip), adhésif conducteur, thermo compression.

Revenant à la figure 5, dans l'exemple, la connexion d'une puce radiofréquence IC à l'antenne est effectuée de préférence sur le premier support 3 à l'aide d'un micomodule STC du type "strap" mais avec une puce IC radiofréquence. La connexion peut être comme précédemment par accrochage mécanique et contact à travers isolant (opération dite "crimp" en anglais) ou par colle conductrice ou thermosoudage.

Une application du type antenne passive est également possible selon ce mode de transfert. Pour cela, avant la fixation du matériau 15, un module M est transféré à proximité ou notamment au centre de l'antenne passive 2 qui serait non connectée à un circuit intégré IC. Le module peut comme précédemment comporter une mini antenne reliée à un circuit intégrée IC.

Ensuite, l'antenne passive 2 peut être enrobée en même temps que le mini transpondeur radiofréquence pour un matériau ou une matière 15.

Le procédé comprend le cas échéant une découpe H du support définitif (plaque ou ruban) pour isoler chaque dispositif ainsi réalisé.

## Revendications

1. Procédé de réalisation d'un dispositif électronique / électrique (1, 20, 30) comportant une interface de communication à antenne (2) et/ou à contacts électriques, ladite interface de communication étant formée sur un support initial (3) selon une première densité (D1) par unité de surface ou de longueur du support,
**caractérisé en ce qu**'il comprend une étape de transfert d'au moins deux interfaces de ladite pluralité d'interfaces (2, 12) sur ou dans un second support définitif (7, 15) selon une seconde densité (D2).

2. Procédé selon l'une quelconque des revendications précédentes, **caractérisé en ce que** la seconde densité (D2) est inférieure à la première densité (D1).

3. Procédé selon la revendication 1, **caractérisé en ce que** ledit dispositif comprend une puce de circuit intégré (IC) connectée à l'interface (2).

4. Procédé selon l'une quelconque des revendications précédentes, **caractérisé en ce que** l'interface est une antenne (2).

5. Procédé selon l'une quelconque des revendications précédentes, **caractérisé en ce que** le premier et/ou second support comprend une bande (3) de bobine 4.

6. Procédé selon l'une quelconque des revendications précédentes, **caractérisé en ce que** le transfert comprend une étape de fixation du support définitif (15) sur les circuits (2) sur leur côté opposé à celui orienté vers le support initial (3) et une étape d'enlèvement d'au moins un support initial externe (5, 3).

7. Procédé selon l'une quelconque des revendications précédentes, **caractérisé en ce que** l'étape de fixation est choisie parmi une opération telle qu'une lamination, un surmoulage, une coextrusion.

8. Procédé selon l'une quelconque des revendications précédentes, **caractérisé en ce que** l'interface est une antenne passive (12) et **en ce qu'**il comprend le transfert et la connexion d'un micromodule à capacité (STC) sur ladite antenne passive et/ou le transfert d'un micromodule à antenne (M, 10) avec circuit intégré de manière à être associé sur le support définitif.

9. Dispositif électronique (1, 20, 30) comportant au moins un circuit électrique/électronique comprenant une interface de communication à antenne (2, 12) et/ou à contacts électriques sur un support définitif (7), **caractérisé en ce que** ledit support définitif de l'interface est dépourvu d'un support initial externe (5) ayant servi à supporter l'interface pendant sa formation.

10. Dispositif électronique (1, 20, 30) selon la revendication précédente, **caractérisé en ce que** ledit support définitif comprend une couche de décollement (6) d'un support initial de formation de l'interface.

11. Dispositif électronique (1, 20, 30) selon la revendication 9, **caractérisé en ce que** l'interface est obtenue par métallisation additive.

12. Dispositif électronique selon la revendication 9, **caractérisé en ce qu**'il comprend une pluralité d'interfaces.
